# EUROPEAN PATENT APPLICATION

(11) **EP 4 510 300 A2**
(43) Date of publication of application: **19.02.2025**
(21) Application number: 24193915.6
(22) Date of filing: 09.08.2024
(51) Int. Cl.: H01M 10/48, G01R 31/367, G01R 31/382, G01R 31/396, H01M 10/42

(54) **METHOD FOR ESTIMATING GROUPING EFFICIENCY, ELECTRONIC DEVICE AND STORAGE MEDIUM**

(30) Priority: 11.08.2023 CN 202311017365; 16.07.2024 WO PCT/CN2024/105735
(71) Applicant: Eve Energy Co., Ltd., Huizhou, Guangdong 516006 (CN)
(72) Inventor: DONG,, Yapeng, Huizhou, Guangdong, 516006 (CN); DENG, Xiaobo, Huizhou, Guangdong, 516006 (CN); LI, Wei, Huizhou, Guangdong, 516006 (CN); ZHAO, Hengxi, Huizhou, Guangdong, 516006 (CN); JIA, Chenxiao, Huizhou, Guangdong, 516006 (CN); TANG, Zhishen, Huizhou, Guangdong, 516006 (CN); LI, Jiaman, Huizhou, Guangdong, 516006 (CN); ZHENG, Yuanyuan, Huizhou, Guangdong, 516006 (CN); XU, Yuhong, Huizhou, Guangdong, 516006 (CN)
(74) Representative: Murgitroyd & Company

(57) **Abstract**

Provided are a method for estimating a grouping efficiency, an electronic device, and a storage medium. The method includes: detecting (101) initial capacities of multiple to-be-grouped battery cells, and grouping, among the to-be-grouped battery cells, battery cells to obtain a first battery pack; detecting (102) an initial SOC of each battery cell in the first battery pack, and grouping the battery cells in the first battery pack to obtain a second battery pack; simulating (103) a charging and discharging process of the second battery pack to obtain charging data and discharging data corresponding to the battery cell; and determining (104) a grouping efficiency of the second battery pack based on the charging data, the discharging data, and a nominal capacity.

## Description

### TECHNICAL FIELD

The present disclosure relates to the field of battery technology, for example, a method for estimating a grouping efficiency, an electronic device, and a storage medium.

### BACKGROUND

Factors that affect the consistency of battery cells include, for example, internal resistance, capacity, state of charge (SOC, the amount of electrical energy remaining in the battery cell), self-discharge, and temperature. Due to these factors, after battery cells are assembled into a system, the capacity/energy of the system cannot be consistent with the battery cells. There is a loss factor for cell to pack (CTP), i.e., a grouping efficiency. The higher the CTP grouping efficiency, the better the consistency between batteries. Therefore, the accurate estimation of battery grouping efficiency is of guiding significance in improving the consistency of batteries.

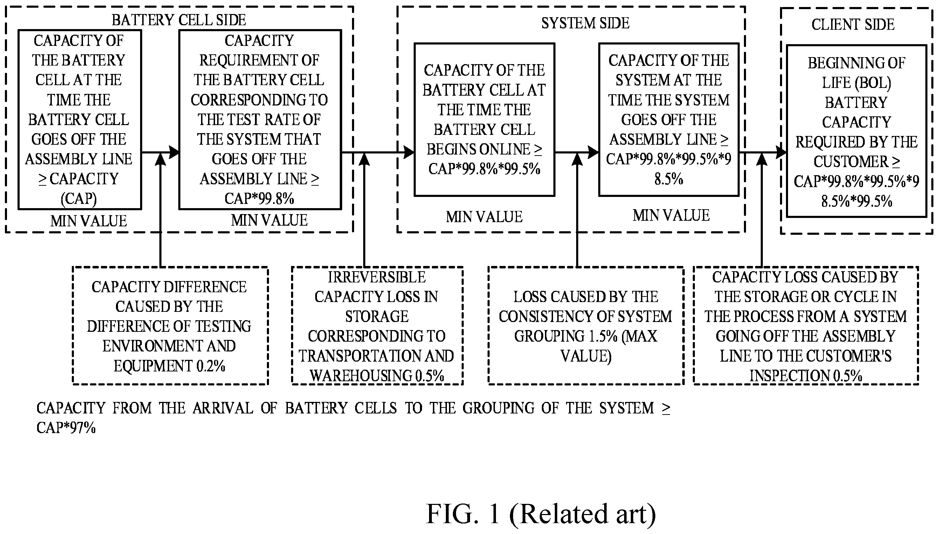

In the related art, the estimation of battery grouping efficiency is usually done by considering all consistency factors, including internal resistance, capacity, SOC, self-discharge, temperature, etc., and by estimating the maximum capacity losses respectively caused by all consistency factors in the grouping process. As shown in Fig. 1, the extremum method is adopted, that is, to estimate the maximum capacity losses respectively caused by all consistency factors in the grouping process and sum up these losses. For example, the minimum value (min value) of capacity loss caused by the difference of testing environment and equipment is 0.2%, the minimum value of capacity loss caused by the storage corresponding to the transportation and storage process is 0.5%, the maximum value (max value) of capacity loss caused by the consistency of system grouping is 1.5%, and the capacity loss caused by the storage or cycle in the process from a system going off the assembly line to the customer's inspection of the battery is 0.5%. Then these values are summed up, and the result of the addition is the total capacity loss, which is 2.7%. The capacity of the battery system, after grouping the battery cells, is determined based on the result of the addition, and a battery grouping efficiency is estimated based on the capacity of the battery system after battery cells being grouped.

### SUMMARY

In a first aspect, embodiments of the present disclosure provide a method for estimating a grouping efficiency, and the method for estimating the grouping efficiency includes the following.

Initial capacities of multiple to-be-grouped battery cells are detected, and, among the to-be-grouped battery cells, battery cells whose initial capacities each satisfy a preset grouping capacity threshold range are grouped to obtain a first battery pack. The preset grouping capacity threshold range is determined based on a nominal capacity of the to-be-grouped battery cells.

An initial SOC of each battery cell in the first battery pack is detected, and the battery cells in the first battery pack whose initial SOCs each satisfy a preset grouping SOC range are grouped to obtain a second battery pack.

A charging and discharging process of each battery cell in the second battery pack is simulated based on a preset charging and discharging strategy to obtain charging data and discharging data corresponding to the battery cell.

A grouping efficiency of the second battery pack is determined based on the charging data, the discharging data, and the nominal capacity.

In a second aspect, embodiments of the present disclosure provide an electronic device, and the electronic device includes at least one processor, a memory, and at least one program.

The memory stores the at least one program. The at least one program, when executed by the at least one processor, causes the at least one processor to implement the steps in any method for estimating the grouping efficiency in the first aspect.

In a third aspect, embodiments of the present disclosure further provide a computer-readable storage medium which stores computer programs. The computer programs are executed by a processor to implement the steps in any method for estimating the grouping efficiency in the first aspect.

### BRIEF DESCRIPTION OF THE DRAWINGS

To illustrate technical solutions in embodiments of the present disclosure more clearly, drawings used in description of the embodiments are briefly described below. Apparently, the drawings described below illustrate only part of the embodiments of the present disclosure, and those of ordinary skill in the art may obtain other drawings based on the drawings described below on the premise that no creative work is done.
FIG. 1 is a schematic diagram illustrating the use of the extremum method to estimate the grouping efficiency of batteries in the Background of the present disclosure.
FIG.2 is a flowchart illustrating an embodiment of a method for estimating a grouping efficiency provided in some embodiments of the present disclosure.
FIG. 3 is a schematic diagram illustrating the structure of an embodiment of an apparatus for estimating a grouping efficiency provided in some embodiments of the present disclosure.
FIG. 4 is a schematic diagram illustrating the structure of an embodiment of an electronic device provided in some embodiments of the present disclosure.

### DETAILED DESCRIPTION

However, considering all consistency factors, including internal resistance, capacity, SOC, self-discharge, temperature, etc., and estimating the maximum capacity loss caused by all consistency factors in the grouping process lead to an unscientific calculation result, which deviates from the actual grouping efficiency. Thus, the accuracy of the estimation of the grouping efficiency of batteries is reduced, resulting in excessive or inadequate capacity design of the battery system after battery cells being grouped.

In view of the above, embodiments of the present disclosure provide a method for estimating a grouping efficiency, an electronic device, and a storage medium, which can improve the situation that the estimation of the grouping efficiency is complicated and has low accuracy, which makes it difficult to maximize the capacity utilization of the battery system after battery cells being grouped.

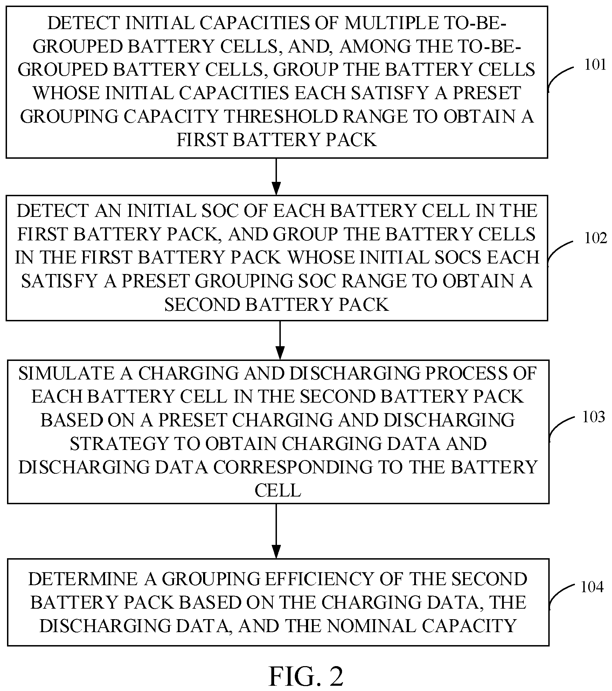

As shown in FIG. 2, which is a flowchart illustrating an embodiment of a method for estimating a grouping efficiency provided in some embodiments of the present disclosure, the method for estimating the grouping efficiency may include step 101, step 102, step 103, and step 104.

At step 101, initial capacities of multiple to-be-grouped battery cells are detected, and, among the to-be-grouped battery cells, the battery cells whose initial capacities each satisfy a preset grouping capacity threshold range are grouped to obtain a first battery pack. The preset grouping capacity threshold range is determined based on a nominal capacity of the to-be-grouped battery cells.

To-be-grouped battery cells may be multiple battery cells of a single production batch or multiple production batches that need to be grouped together. The initial capacity refers to the capacity of a battery cell at the time the battery cell goes off the assembly line, and the capacity of the battery cell may be an actual capacity or a normalized capacity which is the normalized actual capacity.

The preset grouping capacity threshold range refers to a preset capacity interval for selecting a battery cell whose initial capacity satisfies grouping conditions. For example, the preset grouping capacity threshold range is a range of C_{N} to 1.04 * C_{N}, and C_{N} and 1.04 * C_{N} are included in the range, where C_{N} is a nominal capacity of to-be-grouped battery cells, and the nominal capacity of the to-be-grouped battery cells is the smallest rated capacity among the rated capacities corresponding to the multiple to-be-grouped battery cells. The first battery pack refers to a battery pack assembled from the battery cells whose initial capacities each satisfy the preset grouping capacity threshold range.

For example, a corresponding initial capacity may be obtained by identifying the nameplate information of a battery cell, and then, according to the capacity grouping standard, the battery cells whose initial capacities each satisfy the preset grouping capacity threshold range are randomly assembled into the first battery pack. Thus, the initial capacities of the battery cells in the first battery pack all satisfy the preset grouping capacity threshold range, i.e., the consistency of the initial capacities of the battery cells in the first battery pack satisfies the grouping conditions. In the embodiment, selection and grouping are performed based on the initial capacities of the battery cells, thereby fully considering the impact of the capacity of the battery cell on the calculation of the SOC of the battery. The capacity of the battery cell is analyzed as an influencing factor of consistency, thereby ensuring that the consistency of the initial capacities of the battery cells in the first battery pack satisfies the grouping conditions, and contributing to the improvement of the accuracy of the subsequent estimation of the grouping efficiency.

At step 102, an initial SOC of each battery cell in the first battery pack is detected, and the battery cells in the first battery pack, whose initial SOCs each satisfy a preset grouping SOC range, are grouped to obtain a second battery pack.

The initial SOC of a battery cell in the first battery pack refers to the SOC of the battery cell at the time the battery cell goes off the assembly line. For example, the initial SOC may be 30%, 30.01%, 30.03%, and 31%.

The preset grouping SOC range refers to a pre-set SOC interval for selecting a battery cell whose initial SOC satisfies grouping conditions. For example, the preset grouping SOC range is the smallest initial SOC, among the corresponding initial SOCs of the multiple battery cells in the first battery pack, multiplied by 100%-103.4%. For example, when the smallest initial SOC is 30%, the preset grouping SOC range is 30%-31%. The second battery pack refers to a battery pack assembled from the battery cells whose initial capacities each satisfy the preset grouping capacity threshold range and whose initial SOCs each satisfy the preset grouping SOC range.

For example, the initial SOC of each battery cell in the first battery pack may be measured by the open circuit voltage (OCV) method, and the corresponding initial SOC can be obtained. Then, according to the SOC grouping standard, the battery cells in the first battery pack, whose initial SOCs each satisfy the preset grouping SOC range, are randomly assembled into the second battery pack. Thus, the initial SOCs of the battery cells in the second battery pack all satisfy the preset grouping SOC range, i.e., the consistency of the initial SOCs of the battery cells in the second battery pack satisfies the grouping conditions. In the embodiment, the battery cells in the first battery pack, whose initial SOCs each satisfy the preset grouping SOC range, are randomly assembled into the second battery pack, and selection and grouping are performed based on the initial SOCs of the battery cells, thereby fully considering the impact of the SOCs of the battery cells on the cutoff control of battery charging and discharging tests. The SOCs of the battery cells are analyzed as an influencing factor of consistency, thereby ensuring that the consistency of the initial SOCs of the battery cells in the second battery pack satisfies the grouping conditions, and contributing to the improvement of the accuracy of the subsequent estimation of the grouping efficiency.

It is to be noted that, in the embodiment, the first grouping is performed based on the initial capacities of the battery cells, the second grouping is performed based on the initial SOCs, and thereby the second battery pack is obtained for subsequent charging and discharging tests. The second battery pack is formed by grouping based on the capacities and the SOCs of the battery cells, where the two factors affecting the consistency of the battery, namely, the capacity and the SOC, are selected, and there is no need to take into account other factors, such as internal resistance, temperature difference, and self-discharge. Compared with the existing art in which all factors affecting consistency are included in the grouping standard, the embodiments greatly improve the efficiency of battery cell grouping.

It is to be further noted that the reasons for ignoring internal resistance, temperature difference, and self-discharge are: test data in battery cells and battery packs already includes the internal resistance variable, so the impact of internal resistance on grouping efficiency is negligible; the temperature factor is favorable to battery packs, and the capacity is more easily released, so the impact of temperature difference on grouping efficiency is negligible; the grouping efficiency is only for short-time storage, and long-term self-discharge and aging difference are negligible in the scenario of estimating grouping efficiency. Therefore, the embodiments consider the capacity and the SOC, and thus the accuracy of the subsequent estimation of the grouping efficiency can be ensured, reducing the interference caused by factors such as internal resistance, temperature difference, and self-discharge in the estimation of battery grouping efficiency, as well as the redundancy in calculations, and greatly improving the efficiency of battery grouping efficiency estimation.

At step 103, a charging and discharging process of each battery cell in the second battery pack is simulated based on a preset charging and discharging strategy to obtain charging data and discharging data corresponding to the battery cell.

The preset charging and discharging strategy refers to a preset strategy used for determining charging and discharging tests of batteries. For example, the preset charging and discharging strategy may be a condition for stopping charging, a condition for stopping discharging, and the like.

For example, the Monte Carlo simulation method may be used to simulate the charging and discharging process of each battery cell in the second battery pack, i.e., to simulate the battery charging and discharging test process, and the simulation may be a virtual charging and discharging test. The simulation process of charging and discharging tests is as follows: virtual charging is performed based on the preset charging and discharging strategy; after charging is completed, the SOC of each battery cell in the second battery pack is calculated, thereby obtaining the charging data; then virtual discharging is performed; after discharging is completed, the SOC of each battery cell in the second battery pack is calculated, thereby obtaining the discharging data. It is to be understood that in the embodiments, the Monte Carlo simulation method is adopted to simulate the charging and discharging process of the second battery pack, thereby realizing the simulation test of the battery pack, and improving the accuracy of the charging data and the discharging data. The charging and discharging process adopts a virtual charging method, which saves the testing cost.

At step 104, a grouping efficiency of the second battery pack is determined based on the charging data, the discharging data, and the nominal capacity.

For example, an actual discharge capacity of a battery cell in the second battery pack is determined based on the charging data and the discharging data, and the ratio of the actual discharge capacity to the nominal capacity is the grouping efficiency of the second battery pack. In the embodiments, the actual discharge capacity may be determined based on the charging data and discharging data corresponding to each battery cell in the second battery pack, and the grouping efficiency may be estimated based on the actual discharge capacity and the nominal capacity. The estimation method does not require determining extremums and is simple and efficient. Due to the high accuracy of charging and discharging data, the accuracy of grouping efficiency estimation is improved. Compared to the method of using extremums (maximum value or minimum value), the efficiency and scientific rationality of grouping efficiency estimation are improved, thereby avoiding the underestimation or overestimation of product capability in the use of the extremum method.

In the above method for estimating the grouping efficiency, initial capacities of multiple to-be-grouped battery cells are detected, and, among the to-be-grouped battery cells, battery cells whose initial capacities each satisfy a preset grouping capacity threshold range are grouped to obtain a first battery pack. The preset grouping capacity threshold range is determined based on a nominal capacity of the to-be-grouped battery cells. An initial SOC of each battery cell in the first battery pack is detected, and the battery cells in the first battery pack whose initial SOCs each satisfy a preset grouping SOC range are grouped to obtain a second battery pack. A charging and discharging process of each battery cell in the second battery pack is simulated based on a preset charging and discharging strategy to obtain charging data and discharging data corresponding to the battery cell. A grouping efficiency of the second battery pack is determined based on the charging data, the discharging data, and the nominal capacity. The embodiments consider the capacity and the SOC and reduce the interference caused by factors such as internal resistance, temperature difference, and self-discharge in the estimation of battery grouping efficiency, as well as the redundancy in calculations. The simulation test of the battery pack is realized by simulating the charging and discharging process of the second battery pack, and thus the accuracy of the charging data and discharging data is improved. The grouping efficiency can be estimated by simple calculation based on the charging data, the discharging data, and the nominal capacity, and thus the efficiency and scientific rationality of grouping efficiency estimation are greatly improved, thereby avoiding the underestimation or overestimation of product capability in the use of the extremum method.

The preset grouping capacity threshold range is a range of C_{N} to (1 + a)* C_{N}, where C_{N} is the nominal capacity of the to-be-grouped battery cells, and C_{N} and (1 + a)* C_{N} are included in the range, where 0 < a < 0.2.

For example, the preset grouping capacity threshold range is a range of C_{N} to (1 + a)* C_{N}, where C_{N} is the nominal capacity of the to-be-grouped battery cells, and C_{N} and (1 + a)* C_{N} are included in the range, where a may be set according to the high standard of the current battery production industry and the actual demand. The high standard of the current battery production industry refers to a consistency deviation that is 4%. The smaller the value of a is, the narrower the distribution interval of the consistency deviation of the initial capacities of the to-be-grouped battery cells is. For example, the value of a is selected as 0.04, i.e., the initial capacity is greater than or equal to the nominal capacity, and the initial capacity is less than or equal to 104% of the nominal capacity.

In the embodiments, the preset grouping capacity threshold range is set as a range of C_{N} to (1 + a)* C_{N}, where C_{N} is the nominal capacity of the to-be-grouped battery cells, and C_{N} and (1 + a)* C_{N} are included in the range, where 0 < a < 0.2. The selection of the battery cells is more accurate and reasonable, which is conducive to improving the accuracy of the subsequent calculation of the grouping efficiency.

It is to be noted that the preset grouping capacity threshold range may be set flexibly according to the actual situation and adjusted accordingly.

The preset grouping SOC range is a range of b% to (b + c)%, and b% and (b + c)% are included in the range, where 0<b<90, and 0<c<10. The value of b is the smallest initial SOC among the multiple initial SOCs corresponding to the multiple battery cells of the first battery pack.

For example, the preset grouping SOC range is a range of b% to (b + c)%, and b% and (b + c)% are included in the range, where 0<b<90, and 0<c<10. The value of b is the smallest initial SOC among the multiple initial SOCs corresponding to the multiple battery cells of the first battery pack. c may be set according to the high standard of the current battery production industry and the actual demand. The consistency deviation c% may be determined based on the voltage difference, i.e., based on the difference between the voltage corresponding to the initial SOC and the voltage of b. The high standard of the current battery production industry refers to a consistency deviation that is 1%. The smaller the value of c is, the narrower the distribution interval of the consistency deviation of the initial SOCs of the to-be-grouped battery cells is. For example, the value of a is selected as 0.04, i.e., the initial capacity is greater than or equal to the nominal capacity, and the initial capacity is less than or equal to 104% of the nominal capacity; the value of b is selected as 30, and the value of c is selected as 1, i.e., the preset grouping SOC interval is 30%-31%. For example, the difference between the voltage corresponding to the initial SOC and the voltage of b is 5 mv.

In the embodiments, the preset grouping SOC range is set as [b%, (b + c)%], 0<b<90, and 0<c<10. The value of b is the smallest initial SOC among initial SOCs corresponding to the battery cells of the first battery pack. The selection of the battery cells is more accurate and reasonable, which is conducive to improving the accuracy of the subsequent calculation of the grouping efficiency.

It is to be noted that the preset grouping SOC range may be set flexibly according to the actual situation and adjusted accordingly.

The preset charging and discharging strategy includes a preset charging strategy and a preset discharging strategy. The step in which the charging and discharging process of each battery cell in the second battery pack is simulated based on the preset charging and discharging strategy to obtain the charging data and discharging data corresponding to the battery cell includes the following sub-steps: the charging process of each battery cell in the second battery pack is simulated based on the preset charging strategy to have the second battery pack virtually charged and obtain the charging data corresponding to the battery cell; and the discharging process of each battery cell in the virtually charged second battery pack is simulated based on the preset discharging strategy to obtain the discharging data corresponding to the battery cell.

The preset charging strategy refers to a strategy used for the charging test of batteries. For example, the preset charging strategy is to stop the charging test when the SOC of one of the battery cells in the second battery pack is 100%. The preset discharging strategy refers to a strategy used for the discharging test of batteries. For example, the preset discharging strategy is to stop the discharging test when the SOC of one of the battery cells in the second battery pack is 0%.

For example, the charging process of each battery cell in the second battery pack is first simulated based on the preset charging strategy to have the second battery pack virtually charged and obtain the charging data corresponding to the battery cell, and then the discharging process of each battery cell in the virtually charged second battery pack is simulated based on the preset discharging strategy to obtain the discharging data corresponding to the battery cell.

In the embodiments, the charging test of the SOCs is first performed on each battery cell in the second battery pack, and then the discharging test of the SOCs is performed on the second battery pack that has completed the charging test. The test process is consistent with the battery production process, and thus the obtained charging data and discharging data are closer to the actual data, thereby improving the accuracy of the charging data and discharging data.

The preset charging strategy is to stop the simulating of the charging process once the SOC of any one of the battery cells in the second battery pack reaches full charge.

The preset charging strategy is that when the SOC of any one of the battery cells in the second battery pack reaches full charge, the simulating of the charging process is stopped, i.e., the charging is stopped when one battery cell is charged to 100% SOC.

It is to be noted that when the SOC of any one of the battery cells in the second battery pack reaches full charge, at this time, most of the remaining battery cells are not charged to 100%.

The preset discharging strategy is to stop the simulating of the discharging process once the SOC of any one of the battery cells in the virtually charged second battery pack reaches full discharge.

The preset discharging strategy is that when the SOC of any one of the battery cells in the virtually charged second battery pack reaches full discharge, that is, when one battery cell is discharged to 0% SOC, discharging is stopped.

It is to be noted that when the SOC of any one of the battery cells in the virtually charged second battery pack reaches full discharge, at this time, most of the remaining battery cells are not discharged to 0%.

The step in which the grouping efficiency of the second battery pack is determined based on the charging data, the discharging data, and the nominal capacity includes: determining an actual discharge capacity of the second battery pack based on the charging data and the discharging data; and determining the grouping efficiency based on the actual discharge capacity and the nominal capacity.

The actual discharge capacity is the discharged capacity of one battery cell in the second battery pack during the charging and discharging simulation.

For example, the first fully discharged battery cell is first determined based on the discharging data, and then the actual discharge capacity may be determined based on the capacity of the first fully discharged battery cell at the time of stopping charging. Then, the ratio of the actual discharge capacity to the nominal capacity is calculated as the grouping efficiency.

The step in which the actual discharge capacity of the second battery pack is determined based on the charging data and the discharging data includes: determining a fully discharged battery cell based on the discharging data; and determining charging data of the fully discharged battery cell as the actual discharge capacity.

A fully discharged battery cell refers to a battery cell whose discharging data is SOC=0%, and the corresponding charging data of this battery cell is the actual discharge capacity.

In an example, there are three battery cells in the second battery pack with rated capacities of 100Ah, 101Ah, and 102Ah and numbered A, B, and C, respectively. Before charging, the actual capacities of battery cells A, B, and C are 31Ah, 30.3Ah, and 30.62Ah, respectively; after charging, the capacities of battery cells A, B, and C are 100Ah, 99.3Ah, and 99.62Ah, respectively; after discharging, the capacities of battery cells A, B, and C are 0.7Ah, 0Ah, and 1.32Ah, respectively. From the above data, it can be seen that battery cell B is the first to be discharged completely, and battery cell B's capacity after charging is 99.3Ah, i.e., the actual discharge capacity is 99.3Ah. The nominal capacity is the smallest rated capacity among rated capacities of battery cells A, B, and C, i.e., 100Ah. Therefore, the grouping efficiency = 99.3/100 = 99.3%.

After the grouping efficiency of the second battery pack is determined based on the charging data, the discharging data, and the nominal capacity, the grouping efficiency of each second battery pack in multiple batches is obtained, and the statistical computation on the grouping efficiencies of all the second battery packs in the multiple batches is performed to obtain a statistical grouping efficiency.

For example, the grouping efficiency of each of multiple batches of second battery packs is obtained, and then, statistical computation, such as taking the average value, taking the median value, taking the weighted average value, and taking the minimum value, is performed on the grouping efficiencies to obtain the statistical grouping efficiency, which further improves the accuracy of the statistical grouping efficiency.

In some embodiments, a battery pack grouping process standard is determined based on the statistical grouping efficiency and the design requirement of battery packs.

For example, since the statistical grouping efficiency has a high degree of accuracy, the battery pack grouping process standard is determined according to the design requirement of battery packs, and thus the designed battery can fully utilize the performance of each battery cell in the battery pack.

In an example, Table 1 shows data of the initial capacity and initial SOC of each battery cell in the second battery pack. The number of battery cells in series is 96. The initial capacities of the battery cells conform to a normal distribution with a consistency deviation of 4%. The initial SOCs of the battery cells conform to a uniform distribution with a consistency deviation of 1%. The initial capacity and the initial SOC of each battery cell in the second battery pack are randomly generated, and the initial capacity is the normalized capacity of the battery cell. According to steps 101 to 104, a grouping efficiency of the second battery pack may be calculated based on the data of battery cells in Table 1, and the grouping efficiency is 99.41%.

**Table 1, data of the initial capacity and initial SOC of each battery cell in the second battery pack**

| Cell serial number | Initial capacity (normalized capacity of the cell) | Initial SOC/% |
|---|---|---|
| 1 | 1.018 | 30.678 |
| 2 | 1.005 | 30.658 |
| 3 | 1.019 | 30.449 |
| 4 | 1.014 | 30.516 |
| 5 | 1.017 | 30.661 |
| 6 | 1.020 | 30.773 |
| 7 | 1.025 | 30.584 |
| 8 | 1.009 | 30.046 |
| 9 | 1.019 | 30.426 |
| 10 | 1.022 | 30.163 |
| 11 | 1.018 | 30.084 |
| 12 | 1.019 | 30.206 |
| 13 | 1.026 | 30.217 |
| 14 | 1.017 | 30.043 |
| 15 | 1.016 | 30.157 |
| 16 | 1.016 | 30.981 |
| 17 | 1.022 | 30.240 |
| 18 | 1.021 | 31.042 |
| 19 | 1.014 | 30.287 |
| 20 | 1.026 | 30.894 |
| 21 | 1.014 | 30.255 |
| 22 | 1.025 | 31.053 |
| 23 | 1.021 | 31.060 |
| 24 | 1.016 | 30.820 |
| 25 | 1.010 | 30.181 |
| 26 | 1.030 | 30.461 |
| 27 | 1.026 | 30.245 |
| 28 | 1.017 | 30.237 |
| 29 | 1.023 | 30.794 |
| 30 | 1.028 | 30.275 |
| 31 | 1.019 | 30.398 |
| 32 | 1.023 | 30.801 |
| 33 | 1.002 | 31.030 |
| 34 | 1.012 | 30.777 |
| 35 | 1.014 | 30.006 |
| 36 | 1.021 | 30.534 |
| 37 | 1.019 | 30.569 |
| 38 | 1.017 | 31.052 |
| 39 | 1.018 | 30.645 |
| 40 | 1.016 | 30.146 |
| 41 | 1.018 | 30.992 |
| 42 | 1.025 | 30.948 |
| 43 | 1.023 | 30.735 |
| 44 | 1.022 | 30.069 |
| 45 | 1.018 | 30.500 |
| 46 | 1.007 | 30.568 |
| 47 | 1.025 | 30.875 |
| 48 | 1.011 | 30.454 |
| 49 | 1.023 | 30.364 |
| 50 | 1.017 | 30.289 |
| 51 | 1.008 | 30.278 |
| 52 | 1.036 | 30.682 |
| 53 | 1.009 | 30.681 |
| 54 | 1.024 | 30.429 |
| 55 | 1.019 | 30.049 |
| 56 | 1.015 | 30.396 |
| 57 | 1.023 | 30.533 |
| 58 | 1.025 | 30.553 |
| 59 | 1.027 | 30.489 |
| 60 | 1.019 | 30.857 |
| 61 | 1.016 | 30.031 |
| 62 | 1.011 | 30.788 |
| 63 | 1.016 | 30.663 |
| 64 | 1.017 | 30.014 |
| 65 | 1.019 | 30.569 |
| 66 | 1.011 | 30.244 |
| 67 | 1.024 | 30.092 |
| 68 | 1.031 | 30.631 |
| 69 | 1.014 | 30.092 |
| 70 | 1.017 | 31.034 |
| 71 | 1.016 | 30.059 |
| 72 | 1.014 | 30.346 |
| 73 | 1.013 | 30.240 |
| 74 | 1.016 | 30.836 |
| 75 | 1.024 | 30.110 |
| 76 | 1.018 | 30.959 |
| 77 | 1.012 | 30.734 |
| 78 | 1.036 | 30.435 |
| 79 | 1.027 | 30.131 |
| 80 | 1.025 | 30.806 |
| 81 | 1.016 | 30.222 |
| 82 | 1.025 | 30.984 |
| 83 | 1.015 | 31.025 |
| 84 | 1.022 | 30.513 |
| 85 | 1.028 | 30.472 |
| 86 | 1.019 | 30.900 |
| 87 | 1.017 | 30.757 |
| 88 | 1.033 | 30.805 |
| 89 | 1.026 | 30.404 |
| 90 | 1.029 | 30.239 |
| 91 | 1.020 | 30.786 |
| 92 | 1.026 | 30.703 |
| 93 | 1.023 | 30.350 |
| 94 | 1.020 | 30.581 |
| 95 | 1.024 | 30.012 |
| 96 | 1.024 | 30.844 |

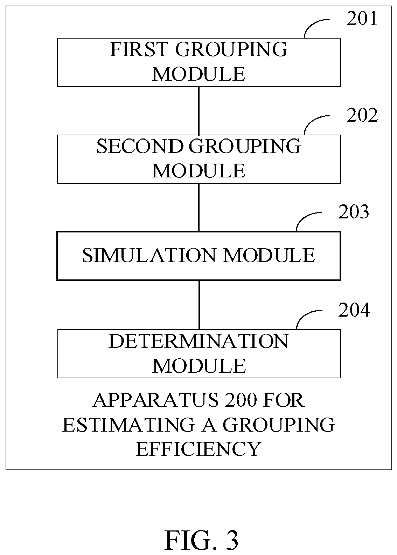

To better realize the method for estimating the grouping efficiency in the embodiments of the present disclosure, based on the method for estimating the grouping efficiency, some embodiments of the present disclosure also provide an apparatus for estimating the grouping efficiency. As shown in FIG.3, the apparatus 200 for estimating the grouping efficiency includes a first grouping module 201, a second grouping module 202, a simulation module 203, and a determination module 204.

The first grouping module 201 is configured to detect initial capacities of multiple to-be-grouped battery cells, and group, among the to-be-grouped battery cells, battery cells whose initial capacities each satisfy a preset grouping capacity threshold range to obtain a first battery pack. The preset grouping capacity threshold range is determined based on a nominal capacity of the to-be-grouped battery cells.

The second grouping module 202 is configured to detect an initial SOC of each battery cell in the first battery pack, and group the battery cells in the first battery pack whose initial SOCs each satisfy a preset grouping SOC range to obtain a second battery pack.

The simulation module 203 is configured to simulate a charging and discharging process of each battery cell in the second battery pack based on a preset charging and discharging strategy to obtain charging data and discharging data corresponding to the battery cell.

The determination module 204 is configured to determine a grouping efficiency of the second battery pack based on the charging data, the discharging data, and the nominal capacity.

In some embodiments, the preset charging and discharging strategy includes a preset charging strategy and a preset discharging strategy. The simulation module 203 is further configured to: simulate the charging process of each battery cell in the second battery pack based on the preset charging strategy to have the second battery pack virtually charged and obtain the charging data corresponding to the battery cell; and simulate the discharging process of each battery cell in the virtually charged second battery pack based on the preset discharging strategy to obtain the discharging data corresponding to the battery cell.

In some embodiments, the determination module 204 is further configured to: determine an actual discharge capacity of the second battery pack based on the charging data and the discharging data; and determine the grouping efficiency based on the actual discharge capacity and the nominal capacity.

In some embodiments, the determination module 204 is further configured to: determine a fully discharged battery cell among the battery cells in the second battery pack based on the discharging data; and determine charging data of the fully discharged battery cell as the actual discharge capacity.

In some embodiments, the apparatus for estimating the grouping efficiency further includes a standard determination module.

The standard determination module is configured to determine a battery pack grouping process standard based on the statistical grouping efficiency and the design requirement of a battery pack.

Some embodiments of the present disclosure also provide an electronic device incorporating any apparatus for estimating the grouping efficiency provided in the embodiments of the present disclosure. The electronic device includes at least one processor, a memory, and at least one program.

The at least one program is stored in the memory. The at least one program is configured to cause, when executed by the at least one processor, the at least one processor to implement the method for estimating the grouping efficiency described in any of the embodiments of the method for estimating the grouping efficiency.

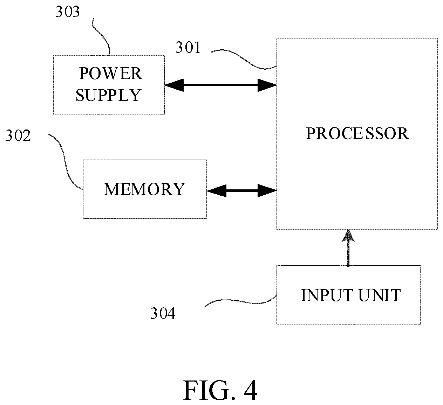

Some embodiments of the present disclosure also provide an electronic device incorporating any apparatus for estimating the grouping efficiency provided in the embodiments of the present disclosure. As shown in FIG. 4, FIG. 4 is a schematic diagram illustrating the structure of an electronic device provided in some embodiments of the present disclosure, and the details are as follows.

The electronic device may include components such as a processor 301 with at least one processing core, a memory 302 with at least one computer-readable storage medium, a power supply 303, and an input unit 304. It will be appreciated by those skilled in the art that the structure of the electronic device illustrated in FIG. 4 does not constitute a limitation of the electronic device, and the electronic device may include more or fewer components than illustrated or may be configured by combining certain components or using different components.

The processor 301 is a control center of the electronic device, connects various parts of the entire electronic device by using various interfaces and lines, and executes the electronic device's various functions and data processing by running or executing software programs and/or modules stored in the memory 302 and invoking data stored in the memory 302, to monitor the electronic device integrally. Optionally, the processor 301 may include at least one processing core. For example, the processor 301 may integrate an application processor and a modem processor. The application processor mainly processes the operating system, the user interface, the application program, and the like. The modem processor mainly processes wireless communication. It will be appreciated that the modem processor may also not be integrated into the processor 301.

The memory 302 may be used to store software programs and modules, and the processor 301 executes various functional applications and data processing by running the software programs and modules stored in the memory 302. The memory 302 may mainly include a program storage area and a data storage area. The program storage area may store an operating system, and at least one application program required for functions (e.g., a sound playback function and an image playback function). The data storage area may store data created according to the use of the electronic device. In addition, the memory 302 may include a high-speed random access memory and may also include a non-volatile memory such as at least one disk memory, a flash memory, or another volatile solid-state memory. Accordingly, the memory 302 may also include a memory controller to provide access to the memory 302 by the processor 301.

The electronic device further includes the power supply 303 which supplies power to the various components. For example, the power supply 303 may be logically connected to the processor 301 through a power supply management system to implement functions such as charging, discharging, and power management through the power supply management system. The power supply 303 may also include at least one direct current or alternating current power source, a re-charging system, a power failure detection circuit, a power converter or inverter, a power status indicator, and any other components.

The electronic device may also include the input unit 304. The input unit 304 may be used for receiving inputted digital or character information and for generating signal input related to user settings and function control, and the signal input relates to a keyboard, a mouse, a pointing stick, an optical signal or a trackball.

Although not shown, the electronic device may also include a display unit and the like, and the details are not repeated here. In the embodiments, the processor 301 in the electronic device loads an executable file corresponding to the process of at least one program into the memory 302 in accordance with the following instructions, and the processor 301 runs the program stored in the memory 302 to realize various functions as follows, such that:

Initial capacities of multiple to-be-grouped battery cells are detected, and, among the to-be-grouped battery cells, battery cells whose initial capacities each satisfy a preset grouping capacity threshold range are grouped to obtain a first battery pack; the preset grouping capacity threshold range is determined based on a nominal capacity of the to-be-grouped battery cells;

An initial SOC of each battery cell in the first battery pack is detected, and the battery cells in the first battery pack whose initial SOCs each satisfy a preset grouping SOC range are grouped to obtain a second battery pack;

A charging and discharging process of each battery cell in the second battery pack is simulated based on a preset charging and discharging strategy to obtain charging data and discharging data corresponding to the battery cell;

A grouping efficiency of the second battery pack is determined based on the charging data, the discharging data, and the nominal capacity.

It is to be understood by those of ordinary skill in the art that all or part of the steps in the methods described in the preceding embodiments may be performed by instructions or by related hardware instructed by instructions, and these instructions may be stored in a computer-readable storage medium and loaded and executed by a processor.

To this end, embodiments of the present disclosure provide a computer-readable storage medium. The computer-readable storage medium may be a non-volatile or volatile storage medium, and the computer-readable storage medium may include a read-only memory (ROM), a random access memory (RAM), a disk, an optical disk or the like. A computer program is stored thereon, and the computer program being loaded by the processor performs the steps in any method for estimating the grouping efficiency provided in the embodiments of the present disclosure. For example, the computer program may be loaded by the processor to perform the following steps, in which:

Initial capacities of multiple to-be-grouped battery cells are detected, and, among the to-be-grouped battery cells, battery cells whose initial capacities each satisfy a preset grouping capacity threshold range are grouped to obtain a first battery pack; the preset grouping capacity threshold range is determined based on a nominal capacity of the to-be-grouped battery cells;

An initial SOC of each battery cell in the first battery pack is detected, and the battery cells in the first battery pack whose initial SOCs each satisfy a preset grouping SOC range are grouped to obtain a second battery pack;

A charging and discharging process of each battery cell in the second battery pack is simulated based on a preset charging and discharging strategy to obtain charging data and discharging data corresponding to the battery cell;

A grouping efficiency of the second battery pack is determined based on the charging data, the discharging data, and the nominal capacity.

Embodiments of the present disclosure also provide a computer program product including a computer program/instruction. The computer program/instruction, when executed by a processor, causes the processor to implement the steps in any method for estimating the grouping efficiency provided in the embodiments of the present disclosure.

## Claims

1. A method for estimating a grouping efficiency, **characterized by** comprising:
detecting (101) initial capacities of a plurality of to-be-grouped battery cells, and grouping, among the to-be-grouped battery cells, battery cells whose initial capacities each satisfy a preset grouping capacity threshold range to obtain a first battery pack, wherein the preset grouping capacity threshold range is determined based on a nominal capacity of the to-be-grouped battery cells;
detecting (102) an initial state of charge, SOC, of each battery cell in the first battery pack, and grouping the battery cells in the first battery pack whose initial SOCs each satisfy a preset grouping SOC range to obtain a second battery pack;
simulating (103) a charging and discharging process of each battery cell in the second battery pack based on a preset charging and discharging strategy to obtain charging data and discharging data corresponding to the battery cell; and
determining (104) a grouping efficiency of the second battery pack based on the charging data, the discharging data, and the nominal capacity.

2. The method for estimating the grouping efficiency according to claim 1, wherein the preset grouping capacity threshold range is a range of C_{N} to (1 + a)* C_{N}, where C_{N} is the nominal capacity of the to-be-grouped battery cells, and C_{N} and (1 + a)* C_{N} are included in the range, and 0 < a < 0.2.

3. The method for estimating the grouping efficiency according to claim 2, wherein the preset grouping SOC range is a range of b% to (b + c)%, and b% and (b + c)% are included in the range, where 0<b<90, and 0<c<10, and wherein b% is a smallest initial SOC among the initial SOCs of the battery cells in the first battery pack.

4. The method for estimating the grouping efficiency according to claim 3, wherein the preset charging and discharging strategy comprises a preset charging strategy and a preset discharging strategy; and
wherein the simulating (103) of the charging and discharging process of each battery cell in the second battery pack based on the preset charging and discharging strategy to obtain the charging data and discharging data corresponding to the battery cell comprises:
simulating the charging process of each battery cell in the second battery pack based on the preset charging strategy to have the second battery pack virtually charged and obtain the charging data corresponding to the battery cell; and
simulating the discharging process of each battery cell in the virtually charged second battery pack based on the preset discharging strategy to obtain the discharging data corresponding to the battery cell.

5. The method for estimating the grouping efficiency according to claim 4, wherein the preset charging strategy is to stop the simulating of the charging process once an SOC of any one of the battery cells in the second battery pack reaches 100%.

6. The method for estimating the grouping efficiency according to claim 5, wherein the preset discharging strategy is to stop the simulating of the discharging process once the SOC of any one of the battery cells in the virtually charged second battery pack reaches 0%.

7. The method for estimating the grouping efficiency according to claim 6, wherein the determining (104) of the grouping efficiency of the second battery pack based on the charging data, the discharging data, and the nominal capacity comprises:
determining an actual discharge capacity of the second battery pack based on the charging data and the discharging data; and
determining the grouping efficiency based on the actual discharge capacity and the nominal capacity.

8. The method for estimating the grouping efficiency according to claim 7, wherein the determining of the actual discharge capacity of the second battery pack based on the charging data and the discharging data comprises:
determining a fully discharged battery cell among the battery cells in the second battery pack based on the discharging data; and
determining charging data of the fully discharged battery cell as the actual discharge capacity.

9. The method for estimating the grouping efficiency according to any one of claims 1 to 8, wherein after the grouping efficiency of the second battery pack is determined (104) based on the charging data, the discharging data, and the nominal capacity, the method further comprises:
obtaining the grouping efficiency of each second battery pack in a plurality of batches; and
performing a statistical computation on the grouping efficiencies of all the second battery packs in the plurality of batches to obtain a statistical grouping efficiency.

10. The method for estimating the grouping efficiency according to claim 9, further comprising:
determining a battery pack grouping process standard based on the statistical grouping efficiency and a design requirement of a battery pack.

11. An electronic device, **characterized by** comprising:
at least one processor (301); and
a memory (302), which is configured to store at least one program;
wherein the at least one program, when executed by the at least one processor (301), causes the at least one processor (301) to implement the method for estimating the grouping efficiency of any one of claims 1 to 10.

12. A storage medium, **characterized in that** the storage medium comprises computer-executable instructions which, when executed by a computer processor, are configured to implement the method for estimating the grouping efficiency of any one of claims 1 to 10.
